Europäisches Patentamt

European Patent Office

Office européen des brevets

(11) Publication number: **0 358 260**
**A1**

## EUROPEAN PATENT APPLICATION

(21) Application number: **89202166.8**

(51) Int. Cl.⁵: **G11C 27/04**

(22) Date of filing: **28.08.89**

(30) Priority: **29.08.88 NL 8802124**

(43) Date of publication of application:
**14.03.90 Bulletin 90/11**

(84) Designated Contracting States:
**DE FR GB NL**

(71) Applicant: **N.V. Philips' Gloeilampenfabrieken**
**Groenewoudseweg 1**
**NL-5621 BA Eindhoven(NL)**

(72) Inventor: **Bakker, Jacobus Gerardus**
**Cornelius**
**c/o INT. OCTROOIBUREAU B.V. Prof.**
**Holstlaan 6**
**NL-5656 AA Eindhoven(NL)**
Inventor: **Esser, Leonard Jan Maria**
**c/o INT. OCTROOIBUREAU B.V. Prof.**
**Holstlaan 6**
**NL-5656 AA Eindhoven(NL)**

(74) Representative: **van Gils, Cornelis Johannes**
**Maria et al**
**INTERNATIONAAL OCTROOIBUREAU B.V.**
**Prof. Holstlaan 6**
**NL-5656 AA Eindhoven(NL)**

(54) Drive shift register for a solid-state image sensor.

(57) As examples for the sensor the frame transfer sensor (FT) and the inter-line sensor are mentioned, the clock pulse-controlled drive shift register (SR) providing between sensor elements an information-transfer under sensor control electrodes (E) coupled thereto, in a transfer period after an information-integration period at sensor elements. In the case of an n-phase drive at the transfer, shift register elements and associated sensor control electrodes are combined into groups (SR1, SR2, SR3, SR4) and (E1, E2, E3, E4), respectively, wherein n is larger than 1. The register elements (SR1, SR2, SR3 and SR4) are each provided with a change-over circuit through which one of a first group (Vh) and one of a second group (Vl) of n voltage conductors (Vh, Vl) are connectable to the associated sensor control electrode (E), the voltage conductors (Vh, Vl) being separately connected to a supply voltage source (HV, LV, TG) which per conductor (Vh and Vl, respectively) are switchable between two voltage values (2V/10V and 0V/8V, respectively). The clock pulse control (Q) and the supply voltage switch (2V/10V, 0V/8V) achieves a compact structure of the shift register (SR) whereas in the sensor (FT) information-charge packets and charge packets of a smear-after-integration-component are shifted forward and a backward shift occurs to remove a smear-before-integration-component.

FIG. 1

## Drive shift register for a solid-state image sensor

The invention relates to a drive shift register for a solid-state image sensor for locally converting in an information-integration period, information sensed by the sensor into electrical charge packets, the charge packets being shiftable in an information-transfer period after the integration period in the sensor under sensor control electrode between sensor elements under the control of the drive shift register, the register comprising register elements having a clock pulse-switchable change-over circuit via which voltage conductors connected to a supply voltage source are connectable to the sensor controle electrode in an n-phase drive.

Such a drive shift register is disclosed in an article in "Philips Technical Review", no. 1/2, 1986, pages 1 to 8, entitled: "The accordion imager, a new solid-state image sensor". The image sensor having sensor elements arranged in rows and columns is designed as what is commonly denoted a frame transfer sensor, the information transfer in the column direction being effected in accordance with the accordion principle. This principle implies that during the frame information-transfer period local shifts of information are effected with an opening, a shifting and a closing phase, the opening phase being a local increase and a shift of the sensor element areas in the column direction, the shifting phase only being shift in the column direction of the "increased" sensor element areas, and the closing phase being a shift and local reduction in the column direction of the (increased) sensor element areas in the appropriate location. For the drive the change-over circuits in the register elements are each provided with 3 MOS-transistors. An n-channel MOS-transistor is operative as a switch, the source electrode being coupled to the preceding register element, clock pulses being applied to the gate electrode as change-over pulses, and the drain electrode being connected to the gate electrodes of a p-channel MOS-transistor and an n-channel MOS-transistor. The source electrode of the p-channel MOS-transistor and of the n-channel MOS-transistor, respectively, is connected to a voltage conductor having a high and a low supply d.c. voltage, respectively, the interconnected drain electrodes on the one hand being connected to the sensor drive electrode and on the other hand to the subsequent register element. In this connection, a four-phase drive during the shifting phase of the accordion principle is described. Depending on the clock pulses and the voltage value from the preceding register element, the high or the low supply d.c. voltage is imprinted on the sensor drive electrode. It is described that interlace for television pictures can be obtained by forming charge packets under predetermined biased sensor electrodes in one frame and under further biased sensor electrodes in the other frame.

The article does not discuss the what is commonly denoted "signal smear" problem. This problem is caused by the continuous information integration in the sensor element, while the information shift through this element occurs. This signal smear is formed by two components, namely a smear-before-integration-component and a smear-after-integration-component. The smear-before-integration-component is present in the sensor elements after the information taken from all the elements has been shifted. Thereafter, during the information-integration period the image information to be sensed is converted into the charge packets. Thereafter, in a subsequent information-transfer period the resultant charge packets are shifted through the sensor elements and the smear-after-integration component is obtained by the continuous integration.

To compensate for the signal smear it is known per se to remove the smear-before-integration component by a reset at the sensor elements before the effective information-integration period starts. The smear-after-integration component can be compensated by a signal subtracting action. In this subtraction operation a first charge packet containing information plus after-smear is reduced by a second, subsequent charge packet only containing after-smear. To that end, the second charge packet subsequent to the first shift of the first charge packet coming from an integrating sensor element, is shifted from the sensor element which is then empty.

It is an object of the invention to provide a drive shift register with which the signal smear compensation can be effected in a simple manner, the register having a compact structure with a minimal number of components per register element. A drive shift register according to the invention is therefore characterized in that the voltage conductors comprise a first and a second group of voltage conductors each having a number of conductors equal to n larger than 1, wherein, with an n-phase drive in which the sensor control electrodes are arranged in groups of n-electrodes, each electrode in the electrode group is separately connectable to an associated voltage conductor of the first and of the second group via the change-over circuit of the associated register element, the voltage conductors being separately coupled to the supply voltage source which is switchable between at least two voltage values for each conductor.

This provides a drive shift register with a compact combination of a logic control realised by the clock pulses and a direct voltage supply to the sensor control electrodes of different, switched supply voltages, the supply voltage switching operation per conductor directly resulting in the obtention of the charge packets associated with the smear-after-integration component and also the removal of the smear-before-integration component by a backward shift. The smear compensation is mentioned as an example.

It should be noted that the smear compensation described is known per se from a lecture and an associated article in IEEE 1988, International Conference on Consumer Electronics, Digest of Technical Papers ICCE, June 8-10, 1988, pages 10 and 11, entitled: "A Smearfree Accordion CCD Imager". For a detailed description of the information transfer and the signal-smear compensation reference is made to this article. The article does not only describe the use in the frame transfer sensor but also in the inter-line sensor.

An embodiment of a drive shift register according to the invention, in which the change-over circuit is provided with a clock pulse-controlled transistor and with two transistors driven via said transistor, said two transistors in the change-over circuit being positioned between the associated sensor control electrode and an associated voltage conductor, is characterized in that in the presence of a control threshold voltage at two transistors, the voltage conductor of the first group and that of the second group carry switched supply d.c. voltages having a voltage difference higher than the control threshold voltage.

These and other (more detailed) aspects of the invention will be described and elucidated with reference to the drawings and examples.

The invention will now be described in greater detail by way of non-limiting example with reference to the accompanying drawing, in which

Fig. 1 is a circuit diagram of a number of register elements of the drive shift register in accordance with the invention, which is coupled to sensor control electrodes of an image sensor;

Fig. 2 shows two diagrams to illustrate the use of switchable supply d.c. voltages for the generation of interlaced picture signals;

Fig. 3 shows a first voltage pattern as a function of time, derived from the switchable supply d.c. voltages, with the aid of clock pulses; and

Fig. 4 shows a second voltage pattern, these two voltage patterns being associated with interlace.

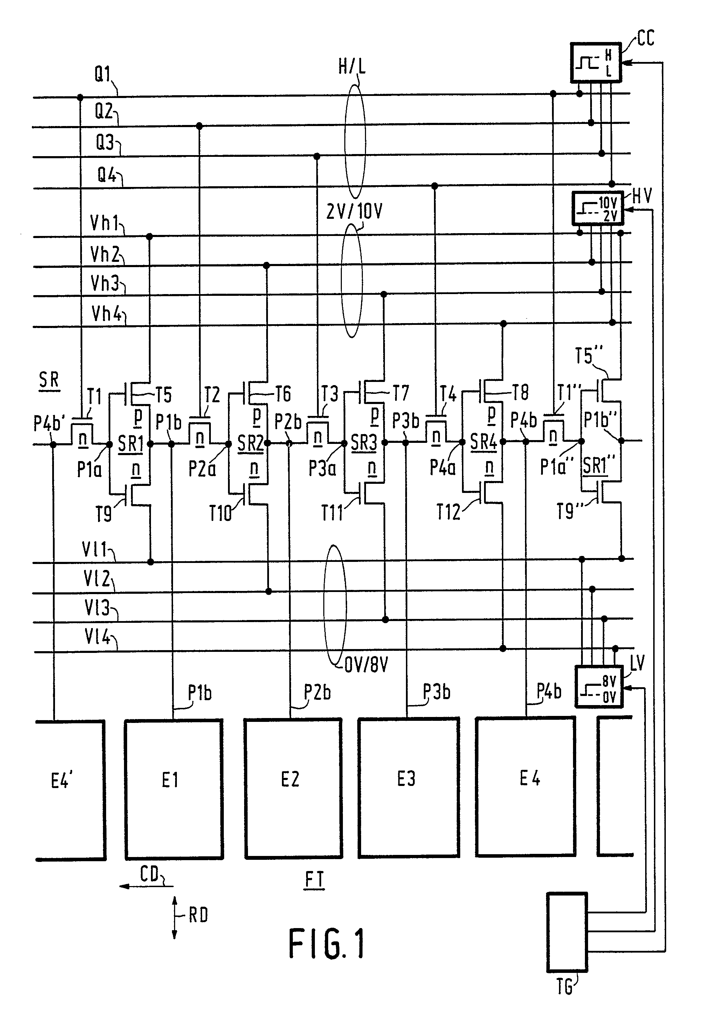

In Fig. 1 references $E4'$, E1, E2, E3 and E4 denote some sensor control electrodes of a solid-state image sensor FT, other parts of which not being shown, the last four electrodes (E1, E2, E3, E4) forming a group. The sensor FT will be described as an example of a frame transfer sensor, but may, as a further example, alternatively be an inter-line sensor. The sensor can be a row-sensor with one row or a plurality of rows of sensor elements or a bi-dimensional sensor having sensor elements which are arranged in rows and columns. In Fig. 1, RD and an arrow having two opposite arrow tips denote the directions of the row of sensor elements for the bi-dimensional sensor. CD denotes an arrow with one single tip which points in the column direction in which information shift occurs. Prior to that the sensor FT is operative for locally converting, in an information-integration period, the information sensed by the sensor in, for example, the form of light rays, into electrical charge packets. In an information-transfer period after the integration period, these charge packets are shifted under the sensor control electrodes E in the sensor FT via the sensor elements, more specifically under the control of a drive shift register denoted by Sr. Five register elements SR1, SR2, SR3, SR4 and $SR1''$ of the shift register SR are shown in detail with MOS-transistors T of the n-channel type, T1 to T4 and $T1''$, T9 to T12 and $T9''$ and with MOS transistors of the p-channel type, T5 to T8 and $T5''$. Instead of the embodiment shown with MOS transistors, thoughts may alternatively go towards an embodiment comprising bipolar transistors. In the register element SR1 which will be described as an example, the source electrode of the transistor T1 is connected to a register element, not shown, which in the register SR precedes this element, the junction point being denoted by $P4b'$. The drain electrode of the transistor T1 is connected to the interconnected gate or control electrodes of the transistors T5 and T9 whose drain electrodes are interconnected. P1a and P1b, respectively, denote the junction points of the gate electrodes and the drain electrodes, respectively. Point P1b of the register element SR1 corresponds to the point $P4b'$ of the preceding register element. The register elements SR2, SR3, SR4 and $SR1''$ are constructed similarly with a minimum of three transistors T (T2, T6, T10), (T3, T7, T11), (T4, T8, T12) and ($T1''$, $T5''$, $T9''$), respectively, and also include the junction points P2a and P2b, P3a and P3b, P4a and P4b and $P1a''$ and $P1b''$, respectively. The junction points $P4b'$, P1b, P2b, P3b and P4b are connected to the respective electrodes $E4'$, E1, E2, E3 and E4.

The gate electrodes of the transistors T1, T2, T3 and T4 are connected as a group to clock pulse conductors Q1, Q2, Q3 and Q4, respectively, which are connected to a clock pulse source CC. The same indication as for the clock pulse conductors Q is used for the clock pulses which are present with a high voltage level H or a low voltage level L, which is denoted by H/L.

The source electrodes of the transistors T5, T6, T7 and T8 are connected as a group to voltage conductors Vh1, Vh2, Vh3 and Vh4 which are connected to a supply voltage source HV. The four voltage conductors Vh constitute a first group (Vh) of conductors having for each conductor a voltage which is switchable between 2 V and 10 V, which is denoted by 2V/10V. Similarly, the source electrodes of the transistors T9, T10, T11 and T12 are connected to voltage conductors V11, V12, V13 and V14 which are connected to voltage supply source LV, a second group (Vl) of conductors being formed carrying a switchable voltage 0V/8V. The voltages 2V/10V and 0V/8V and the clock pulses Q(H/L) wherein, for example H = 12V and L = -2V, which are given by way of example, are produced by the respective sources HV, LV and CC under the control of a time signal generator TG. The generator TG provides that the sources produce matching voltage patterns. In the manner described, the shift register SR is operative with a switchable supply voltage source (HV, LV, TG) and a clock pulse source (CC, TG). In the register elements SR1, SR2, SR3 and SR4 which together form a group of register elements (SR1, SR2, SR3, SR4) which is connected to the group of electrodes (E1, E2, E3, E4), the junction points Pb are connected under the control of a clock pulse and the voltages then present on the junction points Pa, to one of the voltage conductors Vh or Vl, so that each register element includes a change-over circuit (T1, T5, T9), (T2, T6, T10), (T3, T7, T11) and (T4, T8, T12). The given groups are associated with a (n = 4)-phase drive of the electrodes E. The preceding group is given the ′-notation and the subsequent group the ″-notation.

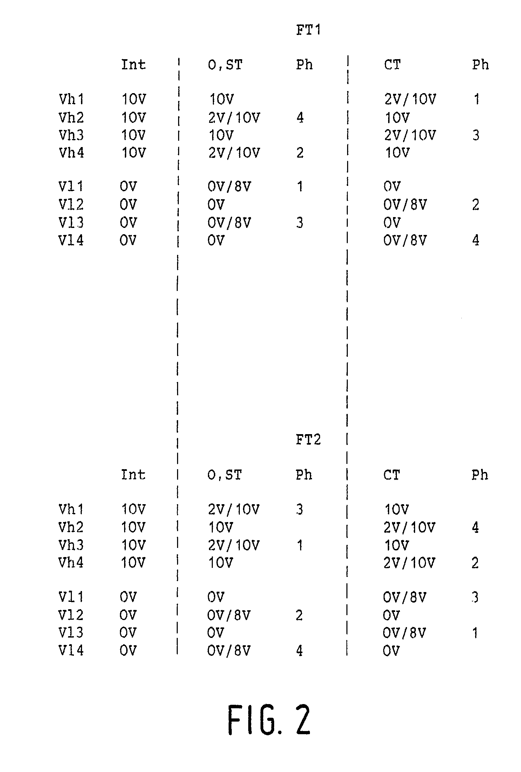

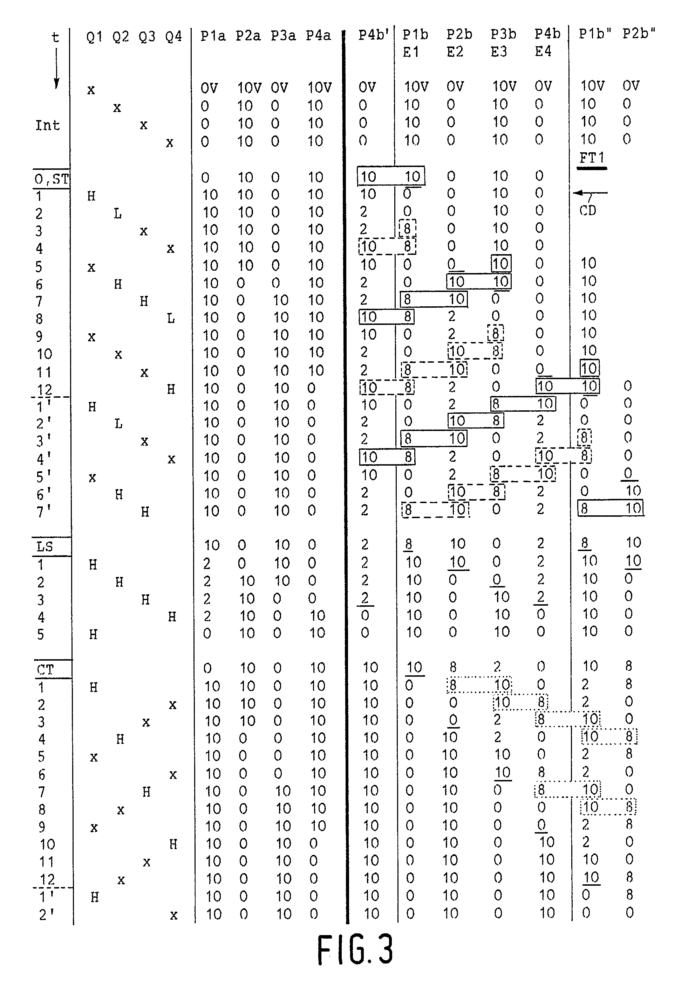

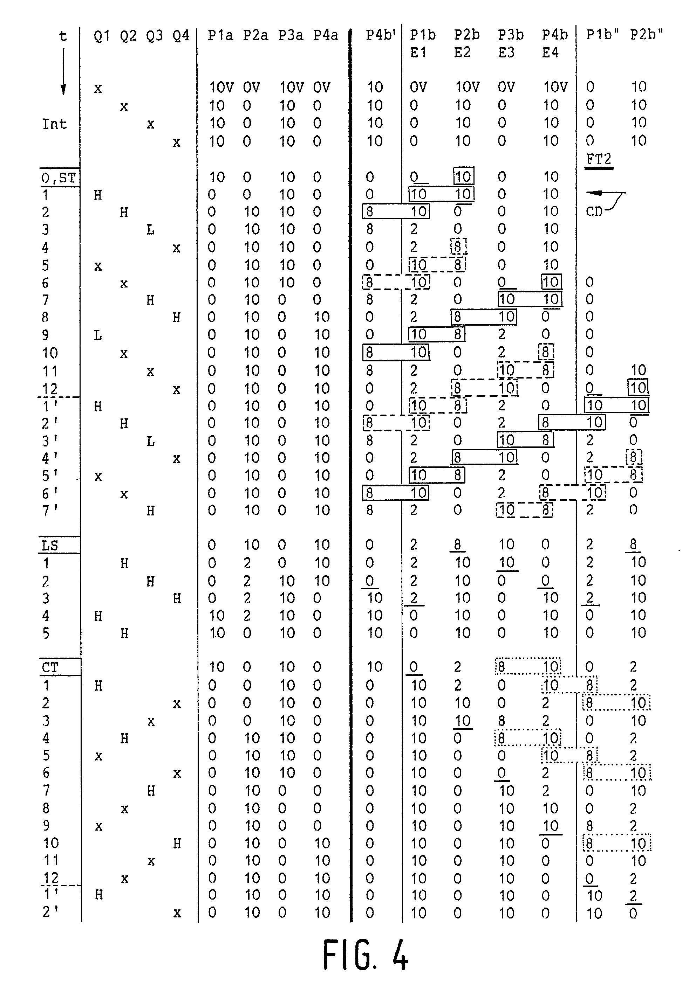

Fig. 2 shows two diagrams to illustrate the use of the switchable supply voltages Vh and Vl on the identically denoted voltage conductors of Fig. 1. FT1 and FT2 denote diagrams associated with an interlaced picture signal generation by the sensor FT. Herein, during the information-integration period which in Fig. 2 is denoted by Int, the voltage Vh are all equal to 10 V and the voltages Vl are all equal to 0V. At FT1, the respective electrodes E1, E3 and E2, E4 are, for example, connected to the respective voltages Vh = 10V and Vl = 0V, while at FT2, the respective electrodes E2, E4 and E1, E3 are connected to the respective voltages Vh = 10V and Vl-0V. Fig. 3 and Fig. 4, respectively, illustrate the voltage supply in a voltage pattern shown as a function of the time t. In accordance with Fig. 1, the voltage conductors Vh carrying the voltage Vh = 10V are through-connected to the electrodes E via one of the transistors T5 to T8, and the voltage conductors Vl carrying the voltage Vl = 0V are through-connected to these electrodes E via one of the transistors T9 to T12.

It being assumed that a frame transfer in accordance with the accordion principle is effected with an opening and shifting, and a closing phase, Fig. 2 shows these phases and the associated time durations by 0,ST and CT, respectively. In addition Ph equal to 1, 2, 3 or 4 indicates the phases of the voltages Vh and Vl such as they occur in each voltage pattern and as they will be explained with reference to the Figs. 3 and 4. Fig. 2 shows at FT1 that during the period (Int + 0,ST) the voltage Vh1 has a constant voltage of 10V and during the period CT it has a switching voltage 2V/10V, while the voltage Vl1 is constantly 0V during the period Int, switches between 0V/8V during the period 0,ST and is again constantly 0V during the period CT. At FT2 Fig. 2 shows that the constant voltage and the switching voltage are interchanged during the period 0,ST and CT at Vh1 and Vl1. A similar interchange is also the case for the other voltages Vh and Vl.

Fig. 3 shows the voltage pattern associated with the first frame of an interlaced picture. At the frame transfer, denoted by FT1, the column direction CD of Fig. 1 is shown. The clock pulses Q1, Q2, Q3 and Q4 are shown as having the high value H and the low value L and an x indicates that either the value H or L can be present, without any influence on the control of the shift register SR of Fig. 1. In those cases in which no H, L or x is denoted at the clock pulses Q the low value should be present. When the values H and L, respectively, are present, the driven transistor T1, T2, T3 or T4 is conducting or non-conducting, respectively. The voltage P1a, P2a, P3a and P4a, occurring at the junction points shown in Fig. 1 and having the same references, are given as having a value 0V and 10V, the value 2V also occurs at the voltage P1a. Associated with the voltages Pa equal to 0V (or 2V) and 10V are inverse voltages P1b, P2b, P3b and P4b at the similarly denoted junction points of 10V or 8V and 0V or 2V, respectively. To explain how the charge packets are shifted under the sensor control electrodes E1, E2, E3 and E4, the voltages P4b′, P1b″ and P2b″ are also partly shown. In the accordion-phases or time periods 0,ST and CT instants are denoted by 1, 2, 3, 4, ..., 11, 12 and 1′, 2′, 3′, ..., 7′. In addition, a time period LS with instants 1, 2, 3, 4, 5 is denoted, in which period a logic shift LS, still further to be described hereinafter, is present at the voltage Pa to prepare the closing-accordion-phase CT.

Fig. 3 shows that during the integration period Int, the information integration is effected in the sensor elements located under the electrodes E1 and E3 with 10V, the 0V on the respective electrodes E2 and E4 producing a barrier in the sensor. The voltage pattern 10 0 10 0 at the electrodes E1, E2, E3 and E4 is produced by the voltages P1b, P2b, P3b and P4b, in Fig. 1 the transistors T5, T10, T7 and T12 being conductive and the transistors T9, T6, T11 and T8 being non-conducting. The inverse voltage pattern 0 10 0 10 of the voltages P1a, P2a, P3a and P4a is associated with the above voltage pattern and it holds for the voltage $P4b'$ that this voltage is equal to 0V. As it holds that $P1a = P4b' = 0V$, $P2a = P1b = 10V$, $P3a = P2b = 0V$ and $P4a = P3b = 10V$, the transistors T1, T2, T3 and T4 may be in both the conducting and the non-conducting mode, which is shown in Fig. 3 by x at the clock pulses Q.

Before the start of the opening and shifting accordion-phase with the duration 0,ST at the electrode group (E1, E2, E3, E4) it is indicated in Fig. 3 for the voltage $P4b'$ that $P4b' = 10V$. This voltage is associated with a periodical phenomenon which in the time and locally precedes the period 0,ST to be described for the electrode groups (E1, E2, E3, E4). The same periodical phenomenon occurs in the period 0,ST at the instant 12, the voltage P4b then corresponding to the voltage $P4b' = 10V$.

At the instant 1 of the period 0,ST a clock pulse Q1 = H occurs at the gate electrode of the transistor T1 of Fig. 1, causing this transistor to become conductive and for the voltages it holds that $P1a = P4b' = 10V$. This results in the transistor T5 being cut off and the transistor T9 to start conducting. In addition it holds that at the instant 1 the voltage P1b is the inverse of the voltage P1a, consequently $P1b = \overline{P1a} = 0V$. Fig. 3 shows at the instant 1 of the period 0,ST the change from 0V to 10V in the voltage P1a and the change from 10V to 0V in the voltage P1b on the electrode E1. In Fig. 3 the latter voltage change from 10V to 0V is stressed by underlining.

At the instant 2 of the period 0,ST it holds that Q2 = L, which causes the transistor T2 to be cut off. This is a requirement since it holds that P2a = 10V and P1b = 0V.

At the instant 3 of the period 0,ST it holds that P3a = P2b = 0V, so that the transistor T3 may be both conducting or non-conducting, it holding that Q3 = x. At the subsequent instants 4 and 5 it holds that Q4 = x and Q1 = x since $P4a = P3b = 10V$ and $P1a = P4b' = 10V$ and $P1a'' = P4b = 0V$.

At the instant 6 of the period 0,ST a clock pulse Q2 = H is present, which causes the transistor T2 to become conductive and it holds that $P2a = P1b = 0V$ and $P2b = \overline{P2a} = 10V$. There is a voltage change 0V/10V at the voltage P2b at the electrode E2, which is stressed by underlining.

At the instant 7 of the period 0,ST a clock pulse Q3 = H occurs, which causes the transistor T3 to become conductive and it holds that $P3a = P2b = 10V$ and $P3b = \overline{P3a} = 0V$. Voltage P3b shows the underlined voltage change 10V/0v. The instant 7 for the electrode E3 corresponds with the instant 1 for the electrode E1. A period of 6 clock pulses having the sequence HLxxxH then occurs.

In the period 0,ST the subsequent period with the 6 clock pulses HLxxxH occurs from the instant 7 to 12. At the instant 12 the underlined voltage change 0V/10V occurs at the electrode E4.

At the instant 12 the opening accordion-phase has ended at the electrode groups (E1, E2, E3, E4). Opening of this phase is illustrated by the rectangles enclosing the single 10 and the double 10, whereafter through-shifting occurs with the rectangles enclosing 8 10 and 10 8. Fig. 3 shows further subsequent instant $1'$, $2'$, ...,$7'$ with the clock pulses of the subsequent period of 6 clock pulses plus one wherein the voltage variation at the voltage $P1b''$ corresponds to the variation at the voltage P1b. From the instant $1'$ only a through-shifting operation occurs under the electrode group (E1, E2, E3, E4), whilst the opening accordion phase continues in the subsequent electrode group with the voltages $Pb''$ with the voltage change 10V/0V given at the voltage $P1b''$ at the instant $1'$ and the voltage change 0V/10V given at the voltage $P2b''$ at the instant $6'$.

The squares enveloping the single 10 are associated with the charge packet generated under the sensor electrodes which are biased to 10V. Such an information-charge packet can, for example for peak white of light incident onto the sensor FT, correspond to a voltage amplitude of 5 to 6V at the given clock pulse and supply voltages. In Fig. 3 a dotted square enclosing 8V is shown inter alia at the instant 9 of the duration 0,ST. Before the instant 7 the sensor element under the electrode E3 has shifted the information-charge packet, whereafter at the instant 10 a further shift from the sensor element which is then "empty" occurs. Thus, the charge packet generated until the instant 6 is followed under the sensor electrode E3 on through-shifting by the "empty" charge packet which on shifting collects the smear-after-integration component. This shift followed by the empty charge packet is illustrated in Fig. 3 by the voltage pattern at the instant $4'$ in the period 0,ST.

During the period 0,ST a continuing shift of charge packets is effected until from the considered, integrating sensor portion all the charge packets have been shifted to an output register of this sensor portion or to a memory portion of the sensor FT. Let it be assumed that this has occurred before the period LS and that just prior to the starting instant 1 thereof the voltage pattern shown in Fig. 3 is present at the voltages Pa, $Pb'$, Pb and $Pb''$.

At the instant 1 of the period LS it holds that Q1 = H, the transistor T1 of Fig. 1 being conductive and it holding for the voltages that $P1a = P4b' = 2V$. The fact that the transistor T5 is in the conducting mode and the voltage Vh1 = 10V results in that it holds that P1b = 10V. This causes an underlined voltage switch 8V/10V at the electrode E1. At the instant 2 of the period LS it holds that Q2 = H, which causes the transistor T2 to become conductive and for the voltages it follows that P2a = P1b = 10V. The fact that the transistor T10 is in the conducting mode and the voltage V12 = 0V has for its result that P2b = 0V. The switch 10V/0V is stressed by underlining it.

Fig. 3 shows at the instants 3 and 4 of the period LS the switches indicated by underlining. At the instant 5 of the period LS Q1 = H and the conducting transistor T1 results in that P1a = P4b' = 0V.

The voltage switch obtained during the period LS is performed to convert the voltage pattern 10 0 10 0 at the voltages P1a, P2a, P3a and P4a into 0 10 0 10, as a preparation for the shift during the period CT. During the period LS there is consequently a logic-shift at the voltages Pa.

In Fig. 3 the voltage pattern associated with the closing-accordion-phase CT is shown at the period CT. The clock pulse control in the described group of 6 clock pulses occurs in the sequence Q1, Q4, Q3, Q2, Q1, Q4 with clock pulses HxxHxx. Starting from the voltage pattern P4b' = 10V, P1b = 10V, P2b = 8V for the period CT which, after positional shift, periodically corresponds to P4b = 10V, P1b'' = 10V, P2b'' = 8V at the instant 12 of the period CT, Q1 = H at the instant 1 results in that it holds that P1a = P4b' = 10V and P1b = $\overline{P1a}$ = 0V. The underlined voltage switch from 10V to 0V at the electrode E1 is the result.

At the instant 2 of the period CT it holds that P4a = P3b = 10V, so that the transistor T4 of Fig. 1 may be conducting or non-conducting and it holds that Q4 = x. The same applies to the instant 3 where Q3 = x and P3a = P2b = 0V at the transistor T3.

At the instant 4 of the period CT it holds that Q2 = H with conducting transistor T2, P2a = P1b = 0V and P2b = $\overline{P2a}$ = 10V. The underlined voltage switch 0V/10V at the electrode E2 is the result.

At the instants 7 and 10 of the period CT the voltage switches 10V/0V and 0V/10V occur with Q3 = H and Q4 = H respectively. The instant 1' illustrates the continuing voltage change at the point P1b''.

Fig. 3 shows that from the respective instant 4 and 10 the electrodes E2 and E4, respectively, are biased by the 10V voltage for the information integration, which state is associated from the instants 7 and 1' with the voltage pattern, shown in Fig. 4 in the period Int. In Fig. 3 dotted rectangles enclosing 8 10 and 10 8 in the period CT illustrate a backward shift which corresponds to a removal of the smear-before-integration-component by an ultimate discharge to a sensor substrate, as described in said article. At the respective instant 4, 5, 6 and 10, 11, 12 of the period CT adjacent electrodes E are biased for information-integration, which, in view of the short duration compared to the entire information-integration period can be neglected for the picture signal generation. Then each sensor picture element has the same information-integration duration shifted in time.

The phase sequences shown in Fig. 2 at the switched d.c. voltage during the frame transfer FT1 during the periods 0,ST and CT can be illustrated with reference to the voltage patterns shown in Fig. 3.

During the period 0,ST, at the instants 1',2', 3' and 4', the electrodes E carry the following voltage patterns: E1 = |0 0 8 8, E2 = 2 10 10|2, E3 = 8 8| 0 0 and E4 = 10 | 2 2 10, wherein | indicates the voltage change from high to low. Associated herewith is the phase sequence Ph = 1, 2, 3 and 4 with E1, E4, E3 and E2, or E1 = Vl1, E4 = Vh4, E3 = Vl3 and E2 = Vh2.

During the period CT, just prior to the closing-accordion-phase and derivable from the voltages P4b'', P2b'', P3b and P4b the following voltage patterns are present on the electrodes E: E1 = |2 2 10 10, E2 = 8 | 0 0 8, E3 = 10 10 | 2 2 and E4 = 0 8 8 | 0, wherein | indicates the voltage change from high to low. Associated herewith is the phase sequence Ph = 1, 2, 3, and 4 with E1, E2, E3 and E4 or E1 = Vh1, E2 = Vl2, E3 = Vh3 and E4 = Vl4.

A description as given with reference to Fig. 3 matches the voltage pattern of Fig. 4. During the period 0,ST the group of 6 clock pulses having the sequence HHLxxx is present. At the shown instant 9 of the period 0,ST it might hold that Q1 = x instead of Q1 = L, since P1a = P4b' = 0V. However, Q1 = L is required since with Pa1'' = 10V (of Fig. 1) it holds that P4b = 0V so that the transistor T1'' must be in the non-conducting state.

The phases Ph at the frame transfer FT2 of Fig. 2, are derivable from Fig. 4 in the manner described with reference to Fig. 3: Duration 0,ST: E1 = 10 10| 2 2, E2 = 8 | 0 0 8, E3 = |2 2 10 10 and E4 = 0 8 8 | 0.
Phase sequence Ph = 1, 2, 3 and 4 with E3, E2, E1 and E4 or E3 = Vh3, E2 = Vl2, E1 = Vh1 and E4 = Vl4
Duration Ct: E1 = 8 8 | 0 0, E2 = 2 10 10 | 2, E3 = | 0 0 8 8 and E4 = 10 | 2 2 10
Phase sequence Ph = 1, 2, 3 and 4 with E3, E4, E1 and E2 or E3 = Vl3, E4 = Vh4, E1 = Vl1 and E2 = Vh2.

The drive shift register SR of Fig. 1 shows a compact combination of the logic control realised by the clock pulses Q with the pulse groups HLxxxH and HxxHxx in accordance with Fig. 3 and HHLxxx and HxxHxx in accordance with Fig. 4 and of the direct voltage supplied to the sensor control electrodes E of the different, switched supply voltages 2V/10V and 0V/8V. Herein the switch of the supply voltage per conductor Vh and Vl directly result the charge packets being obtained (solid rectangles) associated with the smear-after-integration-component and also the removal of the smear-before-integration-component (dotted rectangles) by the backward shift and the ultimate discharge to a sensor substrate.

The choice of 2V/10V and 0V/8V is based on the following consideration. Figs. 3 and 4 show that the junction points Pa carry the voltage 10V or 0v, with the exception of P1a-2V during the period LS. In the event in which Pa-10V, the lowermost transistors (T9, T10, T11 or T12) are conductive and for Pa = 0V the uppepr transistors (T5, T6, T7 or T8) are conductive. With Vl = 8V the lower transistors T can be conductive with Pa = 10V across the gate electrode and 8V across the source electrode and with Vh = 2V the upper transistors T can be conductive with Pa = 0V across the gate electrode and 2V across the source electrode. The voltage difference ensures that with a control threshold voltage between the gate and the source electrode equal to, for example, 1V the upper or lower transistor can always conduct.

In a design of the drive shift register SR wherein the control threshold voltages play no part, for example because of a complicated register element embodiment, the supply conductors Vh and Vl may all have a voltage switch from 0V to 10V.

The drive shift register SR of Fig. 1 shows a (n = 4)-phase shift register, with which the electrode groups of 4 electrodes E and the groups of 4 voltage conductors Vh and Vl are associated. With a general n-phase structure wherein n = 2, 3, 4 etc. the groups of n electrodes E and n voltage conductors Vh and Vl are associated. In this situation each voltage conductor Vh and Vl is switchable between at least two voltage values. The two voltage values 2V and 10V or 0V and 8V have been described, but a shift at the sensor FT while more, optionally continuously switchable voltage values are applied, is possible.

## Claims

1. A drive shift register for a solid-state image sensor for locally converting in an information-integration period information sensed by the sensor into electrical charge packets, the charge packets being shiftable in an information-transfer period after the integration period, in the sensor under sensor control electrodes, between sensor elements under the control of the drive shift register, the register comprising register elements having a clock pulse-switchable change-over circuit, via which voltage conductors connected to a supply voltage source are connectable to the sensor control electrodes in an n-phase drive, characterized in that the voltage conductors comprise a first and a second group of voltage conductors each having a number of conductors equal to n larger than 1, wherein, with an n-phase drive in which the sensor control electrodes are arranged in groups of n electrodes, each electrode in the electrode group is separately connectable to an associated voltage conductor of the firstr and of the second group via the change-over circuit of the associated register element, the voltage conductors being separately coupled to the supply voltage source which is switchable between these two voltage values for each conductor.

2. A drive shift register as claimed in Claim 1, the change-over circuit comprising a clock pulse-controlled transistor and two transistors controlled via said transistor, said two transistors in the change-over circuit being arranged between the associated sensor control electrode and an associated voltage conductor, characterized in that in the presence of a control threshold voltage at said two transistors the voltage conductor of the first group and that of the second group carry switched supply d.c. voltages having a voltage difference higher than the control threshold voltage.

FIG.1

FT1

| | Int | O,ST | Ph | CT | Ph |
|---|---|---|---|---|---|
| Vh1 | 10V | 10V | | 2V/10V | 1 |
| Vh2 | 10V | 2V/10V | 4 | 10V | |
| Vh3 | 10V | 10V | | 2V/10V | 3 |
| Vh4 | 10V | 2V/10V | 2 | 10V | |
| Vl1 | 0V | 0V/8V | 1 | 0V | |
| Vl2 | 0V | 0V | | 0V/8V | 2 |
| Vl3 | 0V | 0V/8V | 3 | 0V | |
| Vl4 | 0V | 0V | | 0V/8V | 4 |

FT2

| | Int | O,ST | Ph | CT | Ph |
|---|---|---|---|---|---|
| Vh1 | 10V | 2V/10V | 3 | 10V | |
| Vh2 | 10V | 10V | | 2V/10V | 4 |
| Vh3 | 10V | 2V/10V | 1 | 10V | |
| Vh4 | 10V | 10V | | 2V/10V | 2 |
| Vl1 | 0V | 0V | | 0V/8V | 3 |
| Vl2 | 0V | 0V/8V | 2 | 0V | |
| Vl3 | 0V | 0V | | 0V/8V | 1 |
| Vl4 | 0V | 0V/8V | 4 | 0V | |

FIG. 2

| t | Q1 | Q2 | Q3 | Q4 | P1a | P2a | P3a | P4a | P4b' | P1b E1 | P2b E2 | P3b E3 | P4b E4 | P1b" | P2b" |
|---|---|---|---|---|---|---|---|---|---|---|---|---|---|---|---|
| ↓ | x | | | | 0V | 10V | 0V | 10V | 0V | 10V | 0V | 10V | 0V | 10V | 0V |
|  | | x | | | 0 | 10 | 0 | 10 | 0 | 10 | 0 | 10 | 0 | 10 | 0 |
| Int | | | x | | 0 | 10 | 0 | 10 | 0 | 10 | 0 | 10 | 0 | 10 | 0 |
|  | | | | x | 0 | 10 | 0 | 10 | 0 | 10 | 0 | 10 | 0 | 10 | 0 |
|  | | | | | | | | | | | | | | FT1 | |
| 0,ST | | | | | 0 | 10 | 0 | 10 | 10 | 10 | 0 | 10 | 0 | | |
| 1 | H | | | | 10 | 10 | 0 | 10 | 10 | 0 | 0 | 10 | 0 | ←7 | |
| 2 | | L | | | 10 | 10 | 0 | 10 | 2 | 0 | 0 | 10 | 0 | CD | |
| 3 | | | x | | 10 | 10 | 0 | 10 | 2 | 8 | 0 | 10 | 0 | | |
| 4 | | | | x | 10 | 10 | 0 | 10 | 10 | 8 | 0 | 10 | 0 | | |
| 5 | x | | | | 10 | 10 | 0 | 10 | 10 | 0 | 0 | 10 | 0 | 10 | |
| 6 | | H | | | 10 | 0 | 0 | 10 | 2 | 0 | 10 | 10 | 0 | 10 | |
| 7 | | | H | | 10 | 0 | 10 | 10 | 2 | 8 | 10 | 0 | 0 | 10 | |
| 8 | | | | L | 10 | 0 | 10 | 10 | 10 | 8 | 2 | 0 | 0 | 10 | |
| 9 | x | | | | 10 | 0 | 10 | 10 | 10 | 0 | 2 | 8 | 0 | 10 | |
| 10 | | x | | | 10 | 0 | 10 | 10 | 2 | 0 | 10 | 8 | 0 | 10 | |
| 11 | | | x | | 10 | 0 | 10 | 10 | 2 | 8 | 10 | 0 | 0 | 10 | |
| 12 | | | | H | 10 | 0 | 10 | 0 | 10 | 8 | 2 | 0 | 10 | 10 | 0 |
| 1' | H | | | | 10 | 0 | 10 | 0 | 10 | 0 | 2 | 8 | 10 | 0 | 0 |
| 2' | | L | | | 10 | 0 | 10 | 0 | 2 | 0 | 10 | 8 | 2 | 0 | 0 |
| 3' | | | x | | 10 | 0 | 10 | 0 | 2 | 8 | 10 | 0 | 2 | 8 | 0 |
| 4' | | | | x | 10 | 0 | 10 | 0 | 10 | 8 | 2 | 0 | 10 | 8 | 0 |
| 5' | x | | | | 10 | 0 | 10 | 0 | 10 | 0 | 2 | 8 | 10 | 0 | 0 |
| 6' | | H | | | 10 | 0 | 10 | 0 | 2 | 0 | 10 | 8 | 2 | 0 | 10 |
| 7' | | | H | | 10 | 0 | 10 | 0 | 2 | 8 | 10 | 0 | 2 | 8 | 10 |
| LS | | | | | 10 | 0 | 10 | 0 | 2 | 8 | 10 | 0 | 2 | 8 | 10 |
| 1 | H | | | | 2 | 0 | 10 | 0 | 2 | 10 | 10 | 0 | 2 | 10 | 10 |
| 2 | | H | | | 2 | 10 | 10 | 0 | 2 | 10 | 0 | 0 | 2 | 10 | 0 |
| 3 | | | H | | 2 | 10 | 0 | 0 | 2 | 10 | 0 | 10 | 2 | 10 | 0 |
| 4 | | | | H | 2 | 10 | 0 | 10 | 0 | 10 | 0 | 10 | 0 | 10 | 0 |
| 5 | H | | | | 0 | 10 | 0 | 10 | 0 | 10 | 0 | 10 | 0 | 10 | 0 |
| CT | | | | | 0 | 10 | 0 | 10 | 10 | 10 | 8 | 2 | 0 | 10 | 8 |
| 1 | H | | | | 10 | 10 | 0 | 10 | 10 | 0 | 8 | 10 | 0 | 2 | 8 |
| 2 | | | | x | 10 | 10 | 0 | 10 | 10 | 0 | 0 | 10 | 8 | 2 | 0 |
| 3 | | | x | | 10 | 10 | 0 | 10 | 10 | 0 | 0 | 2 | 8 | 10 | 0 |
| 4 | | H | | | 10 | 0 | 0 | 10 | 10 | 0 | 10 | 2 | 0 | 10 | 8 |
| 5 | x | | | | 10 | 0 | 0 | 10 | 10 | 0 | 10 | 10 | 0 | 2 | 8 |
| 6 | | | | x | 10 | 0 | 0 | 10 | 10 | 0 | 10 | 10 | 8 | 2 | 0 |
| 7 | | | H | | 10 | 0 | 10 | 10 | 10 | 0 | 10 | 0 | 8 | 10 | 0 |
| 8 | | x | | | 10 | 0 | 10 | 10 | 10 | 0 | 10 | 0 | 0 | 10 | 8 |
| 9 | x | | | | 10 | 0 | 10 | 10 | 10 | 0 | 10 | 0 | 0 | 2 | 8 |
| 10 | | | | H | 10 | 0 | 10 | 0 | 10 | 0 | 10 | 0 | 10 | 2 | 0 |
| 11 | | | x | | 10 | 0 | 10 | 0 | 10 | 0 | 10 | 0 | 10 | 10 | 0 |
| 12 | | x | | | 10 | 0 | 10 | 0 | 10 | 0 | 10 | 0 | 10 | 10 | 8 |
| 1' | H | | | | 10 | 0 | 10 | 0 | 10 | 0 | 10 | 0 | 10 | 0 | 8 |
| 2' | | | | x | 10 | 0 | 10 | 0 | 10 | 0 | 10 | 0 | 10 | 0 | 0 |

FIG.3

3 —IV— PHN 12658

| t | Q1 | Q2 | Q3 | Q4 | P1a | P2a | P3a | P4a | P4b' | P1b E1 | P2b E2 | P3b E3 | P4b E4 | P1b" | P2b" |
|---|---|---|---|---|---|---|---|---|---|---|---|---|---|---|---|
| ↓ | x | | | | 10V | 0V | 10V | 0V | 10 | 0V | 10V | 0V | 10V | 0 | 10 |
| | | x | | | 10 | 0 | 10 | 0 | 10 | 0 | 10 | 0 | 10 | 0 | 10 |
| Int | | | x | | 10 | 0 | 10 | 0 | 10 | 0 | 10 | 0 | 10 | 0 | 10 |
| | | | | x | 10 | 0 | 10 | 0 | 10 | 0 | 10 | 0 | 10 | 0 | 10 |
| | | | | | | | | | | | | | | FT2 | |
| 0,ST | | | | | 10 | 0 | 10 | 0 | 0 | 0 | 10 | 0 | 10 | | |
| 1 | H | | | | 0 | 0 | 10 | 0 | 0 | 10 | 10 | 0 | 10 | CD | |
| 2 | | H | | | 0 | 10 | 10 | 0 | 8 | 10 | 0 | 0 | 10 | | |
| 3 | | | L | | 0 | 10 | 10 | 0 | 8 | 2 | 0 | 0 | 10 | | |
| 4 | | | | x | 0 | 10 | 10 | 0 | 0 | 2 | 8 | 0 | 10 | | |
| 5 | x | | | | 0 | 10 | 10 | 0 | 0 | 10 | 8 | 0 | 10 | | |
| 6 | | x | | | 0 | 10 | 10 | 0 | 8 | 10 | 0 | 0 | 10 | 0 | |
| 7 | | | H | | 0 | 10 | 0 | 0 | 8 | 2 | 0 | 10 | 10 | 0 | |
| 8 | | | | H | 0 | 10 | 0 | 10 | 0 | 2 | 8 | 10 | 0 | 0 | |
| 9 | L | | | | 0 | 10 | 0 | 10 | 0 | 10 | 8 | 2 | 0 | 0 | |
| 10 | | x | | | 0 | 10 | 0 | 10 | 8 | 10 | 0 | 2 | 8 | 0 | |
| 11 | | | x | | 0 | 10 | 0 | 10 | 8 | 2 | 0 | 10 | 8 | 0 | 10 |
| 12 | | | | x | 0 | 10 | 0 | 10 | 0 | 2 | 8 | 10 | 0 | 0 | 10 |
| 1' | H | | | | 0 | 10 | 0 | 10 | 0 | 10 | 8 | 2 | 0 | 10 | 10 |
| 2' | | H | | | 0 | 10 | 0 | 10 | 8 | 10 | 0 | 2 | 8 | 10 | 0 |
| 3' | | | L | | 0 | 10 | 0 | 10 | 8 | 2 | 0 | 10 | 8 | 2 | 0 |
| 4' | | | | x | 0 | 10 | 0 | 10 | 0 | 2 | 8 | 10 | 0 | 2 | 8 |
| 5' | x | | | | 0 | 10 | 0 | 10 | 0 | 10 | 8 | 2 | 0 | 10 | 8 |
| 6' | | x | | | 0 | 10 | 0 | 10 | 8 | 10 | 0 | 2 | 8 | 10 | 0 |
| 7' | | | H | | 0 | 10 | 0 | 10 | 8 | 2 | 0 | 10 | 8 | 2 | 0 |
| LS | | | | | 0 | 10 | 0 | 10 | 0 | 2 | 8 | 10 | 0 | 2 | 8 |
| 1 | | H | | | 0 | 2 | 0 | 10 | 0 | 2 | 10 | 10 | 0 | 2 | 10 |
| 2 | | | H | | 0 | 2 | 10 | 10 | 0 | 2 | 10 | 0 | 0 | 2 | 10 |
| 3 | | | | H | 0 | 2 | 10 | 0 | 10 | 2 | 10 | 0 | 10 | 2 | 10 |
| 4 | H | | | | 10 | 2 | 10 | 0 | 10 | 0 | 10 | 0 | 10 | 0 | 10 |
| 5 | | H | | | 10 | 0 | 10 | 0 | 10 | 0 | 10 | 0 | 10 | 0 | 10 |
| CT | | | | | 10 | 0 | 10 | 0 | 10 | 0 | 2 | 8 | 10 | 0 | 2 |
| 1 | H | | | | 0 | 0 | 10 | 0 | 0 | 10 | 2 | 0 | 10 | 8 | 2 |
| 2 | | | | x | 0 | 0 | 10 | 0 | 0 | 10 | 10 | 0 | 2 | 8 | 10 |
| 3 | | | x | | 0 | 0 | 10 | 0 | 0 | 10 | 10 | 8 | 2 | 0 | 10 |
| 4 | | H | | | 0 | 10 | 10 | 0 | 0 | 10 | 0 | 8 | 10 | 0 | 2 |
| 5 | x | | | | 0 | 10 | 10 | 0 | 0 | 10 | 0 | 0 | 10 | 8 | 2 |
| 6 | | | | x | 0 | 10 | 10 | 0 | 0 | 10 | 0 | 0 | 2 | 8 | 10 |
| 7 | | | H | | 0 | 10 | 0 | 0 | 0 | 10 | 0 | 10 | 2 | 0 | 10 |
| 8 | | x | | | 0 | 10 | 0 | 0 | 0 | 10 | 0 | 10 | 10 | 0 | 2 |
| 9 | x | | | | 0 | 10 | 0 | 0 | 0 | 10 | 0 | 10 | 10 | 8 | 2 |
| 10 | | | | H | 0 | 10 | 0 | 10 | 0 | 10 | 0 | 10 | 0 | 8 | 10 |
| 11 | | | x | | 0 | 10 | 0 | 10 | 0 | 10 | 0 | 10 | 0 | 0 | 10 |
| 12 | | x | | | 0 | 10 | 0 | 10 | 0 | 10 | 0 | 10 | 0 | 0 | 2 |
| 1' | H | | | | 0 | 10 | 0 | 10 | 0 | 10 | 0 | 10 | 0 | 10 | 2 |
| 2' | | | | x | 0 | 10 | 0 | 10 | 0 | 10 | 0 | 10 | 0 | 10 | 0 |

## FIG. 4

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | EP-A-0 275 576 (PHILIPS)<br>* Column 3, line 44 - column 9, line 1; figures 1-8 *<br>--- | 1-2 | G 11 C 27/04 |
| A | US-A-4 745 481 (TANAKA)<br>* Column 11, line 67 - column 14, line 24, figures 1-7 *<br>--- | 1-2 | |
| A | EP-A-0 148 786 (SHARP)<br>* Page 6, line 9 - page 11, line 9; figures 1-7 *<br>--- | 1 | |
| A | EP-A-0 161 023 (PHILIPS)<br>* Page 4, line 36 - page 17, line 2; figures 1-3 *<br>--- | 1 | |
| A | EP-A-0 128 615 (PHILIPS)<br>* Page 4, line 22 - page 14, line 34; figures 1-3 *<br>----- | 1 | |

TECHNICAL FIELDS
SEARCHED (Int. Cl.5)

G 11 C 27/00
H 04 N 3/00
H 04 N 5/00
H 01 L 27/00

The present search report has been drawn up for all claims

| Place of search | Date of completion of the search | Examiner |
|---|---|---|
| THE HAGUE | 07-12-1989 | GEOGHEGAN C.H.B. |